# EUROPEAN PATENT APPLICATION

(11) **EP 4 830 805 A1**
(43) Date of publication of application: **28.10.2026**
(21) Application number: 26163091.7
(22) Date of filing: 09.03.2026
(51) Int. Cl.: A63F 13/98, A63F 13/24, H02J 7/34, H02J 7/70

(54) **GAME CONTROLLER CHARGING DEVICE**

(30) Priority: 27.04.2025 CN 202520817408 U
(71) Applicant: Shenzhen DeOne Innovation Technology Co., Ltd, Shenzhen, Guangdong 518000 (CN)
(72) Inventor: XIE, Huayong, Shenzhen, 518000 (CN); HE, Beijing, Shenzhen, 518000 (CN); JIANG, Dezhong, Shenzhen, 518000 (CN)
(74) Representative: Metida

(57) **Abstract**

A game controller charging device for a game controller is provided. The game controller has buttons provided on a first surface in a first direction. The game controller charging device includes a front protective shell and a charging module detachably connected to the game controller. The charging module is configured to charge the game controller, the front protective shell is detachably connected to the charging module, and the front protective shell covers a side of the charging module in the first direction and covers a side of the game controller in the first direction.

## Description

### TECHNICAL FIELD

The present application relates to the technical field of game peripherals, and in particular, to a game controller charging device.

### BACKGROUND

Most gaming consoles on the market are modular, where the main unit and the game controllers are detachably connected. Users connect the main unit to a television or a display screen, and then use the game controllers for gameplay.

Typically, a mounting end of a game controller is used to connect the main unit. When the game controller is detached from the main unit, a controller accessory or a game controller charging device can be connected to the mounting end.

Conventional game controller charging devices are detachably and electrically connected to the game controller and are configured to charge the game controllers. During the charging process, most portions of the game controller, except the portion connected to the game controller charging device, remain exposed to the air. Dust in the air can adhere to the game controller, such as on its buttons, which may impair user experience after charging.

Furthermore, users might place a combined unit of the game controller charging device and the game controller into a bag for portability while charging. During this process, either the game controller charging device or the game controller is susceptible to collisions or scratches from other items in the bag, which may cause damage to either the game controller or the game controller charging device.

### SUMMARY

In order to solve shortcomings in existing technologies, the present application is to provide a game controller charging device. The game controller charging device charges the game controller through a detachable and electrical connection between a charging module and the game controller. By detachably connecting a front protective shell to the charging module, the front protective shell covers a side of both the charging module and the game controller in the first direction, thereby covering the buttons on the game controller. It prevents dust from adhering to the buttons, enhances the user's gaming experience, and simultaneously shields that side of the game controller from collisions or scratches, thereby preventing damage to the game controller and extending a service life of the game controller.

A game controller charging device for a game controller is provided. The game controller has buttons provided on a first surface in a first direction. The game controller charging device includes a front protective shell and a charging module detachably connected to the game controller. The charging module is configured to charge the game controller, the front protective shell is detachably connected to the charging module, and the front protective shell covers a side of the charging module in the first direction and covers a side of the game controller in the first direction.

After adopting the above technical solution, the beneficial effects of the present application are as follows: the game controller charging device charges the game controller through the detachable and electrical connection between the charging module and the game controller. By detachably connecting the front protective shell to the charging module and covering the side of both the charging module and the game controller in the first direction, the buttons on the game controller are protected. This prevents dust from adhering to the buttons and enhances the user's gaming experience. Simultaneously, it shields that side of the game controller from collisions or scratches, thereby preventing damage to the game controller and extending the service life of the game controller.

### BRIEF DESCRIPTION OF THE DRAWINGS

In order to more clearly illustrate technical solutions in embodiments of the present application or in the prior art, drawings required for describing the embodiments or the prior art will be briefly introduced below. Obviously, the drawings in the following description are merely some embodiments of the present application. For those of ordinary skilled in the art, other drawings may be derived from these drawings without creative effort.
FIG. 1 is a schematic structural view of a game controller charging device according to an embodiment of the present application.
FIG. 2 is an exploded view of the game controller charging device according to an embodiment of the present application.
FIG. 3 is a cross-sectional view taken along line A-A' in FIG. 1.
FIG. 4 is a schematic structural view of a front protective shell according to an embodiment of the present application.
FIG. 5 is an enlarged schematic view of portion B in FIG. 4.
FIG. 6 is an exploded view of a charging module according to an embodiment of the present application.
FIG. 7 is a schematic structural view of a second housing according to an embodiment of the present application.

### Reference Numerals:

1000, game controller charging device; 100, front protective shell; 11, first main body; 111, button avoidance portion; 112, storage module; 1121, first engaging protrusion; 1122, second engaging protrusion; 1123, transverse rib; 1124, longitudinal rib; 12, first engagement portion; 121, first engagement rib; 122, charging avoidance port; 13, second engagement portion; 131, second engagement rib; 14, handle portion; 141, recess; 200, charging module; 21, housing; 211, first housing; 2111, second main body; 21111, first charging avoidance groove; 2112, controller connection portion; 21121, mounting groove; 21122, heat staking post; 21123, first magnetic positioning portion; 21124, electrical connection avoidance hole; 212, second housing; 2121, second magnetic positioning portion; 2122, second charging avoidance groove; 2131, first circuit board; 2132, charging connector; 2133, second circuit board; 21331, heat staking hole; 2134, electrical connection member; 2135, battery cell; 214, magnetic member; 215, accommodation cavity; 300, controller protective shell; 31, grip portion; 2000, game cartridge; X, first direction; Y, second direction; Z, third direction.

### DETAILED DESCRIPTION OF THE EMBODIMENTS

The following provides a further detailed description of the present application in conjunction with the accompanying drawings.

The embodiments are merely an illustration of the present application and is not to be construed as limiting it. Upon reading this specification, those skilled in the art may make non-creative modifications to the embodiments as needed, provided that all such modifications falling within the scope of the claims of the present application are protected by the Patent Law.

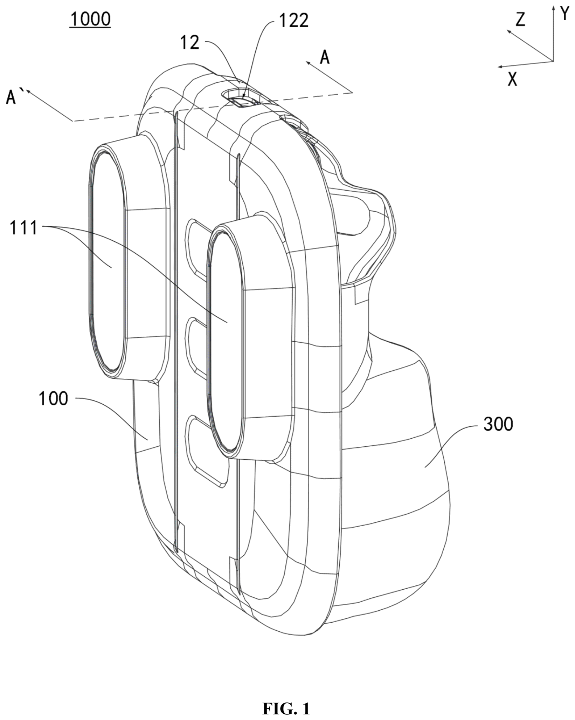

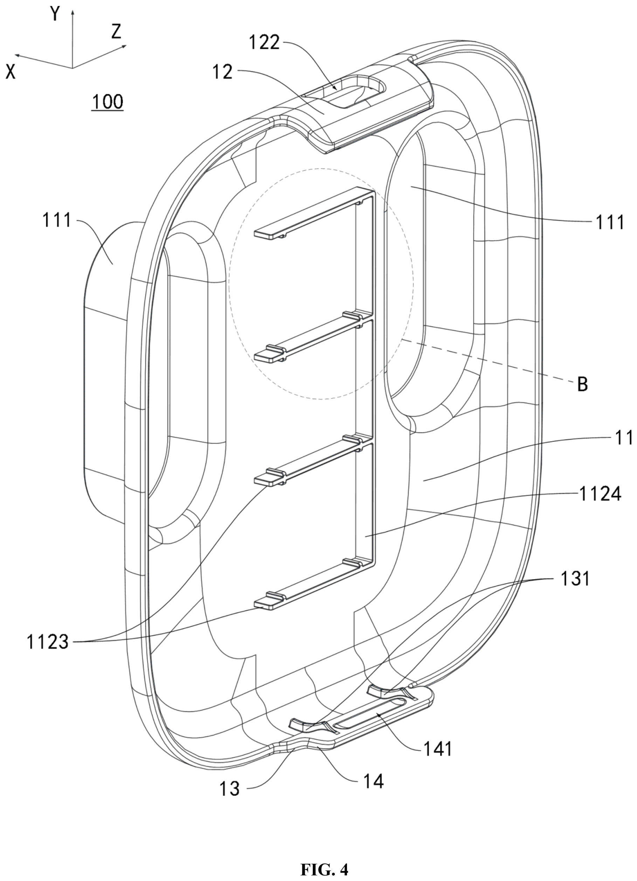

As shown in FIGS. 1-4, an embodiment of the present application provides a game controller charging device 1000, which is configured to charge a game controller. The game controller has buttons provided on a side in a first direction X.

The game controller charging device 1000 includes a front protective shell 100 and a charging module 200. The charging module 200 is detachably and electrically connected to the game controller to enable the charging module 200 to charge the game controller. The front protective shell 100 is detachably connected to the charging module 200. Furthermore, the front protective shell 100 covers a side of the charging module 200 in the first direction X, and covers a side of the game controller in the first direction X, thereby covering the buttons provided on the side of the game controller. It can prevent the buttons and the game controller from accumulating dust from the air, avoids users encountering dust when using the game controller after charging, and thus improves the user's gaming experience. It further protects the side of the game controller in the first direction X from collisions or scratches, thereby preventing damage to the game controller, extending the service life of the game controller, and preserving aesthetic appeal of the game controller.

In the embodiment, the first direction X is a thickness direction of the game controller charging device 1000, a second direction Y is a length direction of the game controller charging device 1000, and a third direction Z is a width direction of the game controller charging device 1000.

As shown in FIGS. 1-4, the front protective shell 100 includes a first main body 11, a first engagement portion 12, and a second engagement portion 13. The first main body 11 covers the side of the charging module 200 in the first direction X and the side of the game controller in the first direction X. The first engagement portion 12 and the second engagement portion 13 are respectively arranged at two opposite ends of the first main body 11. The first engagement portion 12 and the second engagement portion 13 engage with the charging module 200 to detachably connect the charging module 200 and the front protective shell 100.

In other embodiments, the connection between the charging module 200 and the front protective shell 100 may be one of a magnetic connection, a slide rail connection, or a threaded connection.

In this embodiment, the first main body 11 is provided with a button avoidance portion 111 protruding in the first direction X. The button avoidance portion 111 defines an avoidance space in a direction opposite to the first direction X, and is configured to accommodate the buttons on the side of the game controller in the first direction X.

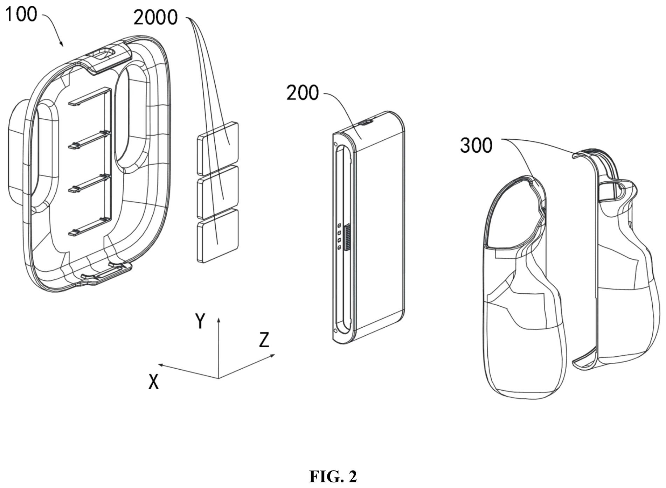

As shown in FIGS. 2-4, defining a direction from the second engagement portion 13 towards the first engagement portion 12 as the second direction Y, the second direction Y is perpendicular to the first direction X. The first engagement portion 12 extends at least partially in the direction opposite to the first direction X, and an end of the first engagement portion 12 facing away from the first main body 11 extends at least partially in the direction opposite to the second direction Y, so that the first engagement portion 12 extends to a side of the charging module 200 opposite the first main body 11. Thus, the first engagement portion 12 applies a force on the charging module 200 in the first direction X, while the first main body 11 applies a force on the charging module 200 in the direction opposite to the first direction X, thereby engaging an end of the charging module 200 in the second direction Y. The second engagement portion 13 extends at least partially in the direction opposite to the first direction X, and an end of the second engagement portion 13 facing away from the first main body 11 extends at least partially in the second direction Y. Consequently, the second engagement portion 13 applies a force on the charging module 200 in the first direction X, while the first main body 11 applies a force on the charging module 200 in the direction opposite to the first direction X, thereby engaging an opposite end of the charging module 200 in the direction opposite to the second direction Y.

As shown in FIGS. 2-4, a side of the first engagement portion 12 facing the charging module 200 is provided with a first engagement rib 121. At least a part of the first engagement rib 121 is arranged adjacent to an end of the first engagement portion 12 away from the first main body 11. A side of the second engagement portion 13 facing the charging module 200 is provided with a second engagement rib 131. At least a part of the second engagement rib 131 is arranged adjacent to an end of the second engagement portion 13 facing away from the first main body 11.

When the front protective shell 100 and the charging module 200 are assembled into an integral unit, the first engagement rib 121 abuts against the charging module 200 to apply a force on the charging module 200 in the first direction X. Simultaneously, this arrangement creates a certain gap between the first engagement portion 12 and the charging module 200, facilitating insertion of a user's finger between the first engagement portion 12 and the charging module 200. This makes it easier for the user to pry the first engagement portion 12, thereby facilitating disassembly of the front protective shell 100 and the charging module 200.

When the front protective shell 100 and the charging module 200 are assembled into the integral unit, the second engagement rib 131 abuts against the charging module 200 to apply a force on the charging module 200 in the first direction X. Simultaneously, this arrangement creates a certain gap between the second engagement portion 13 and the charging module 200, facilitating the insertion of a user's finger between the second engagement portion 13 and the charging module 200. This makes it easier for the user to pry the second engagement portion 13, thereby facilitating the disassembly of the front protective shell 100 and the charging module 200.

Through arrangement of the first engagement rib 121 and the second engagement rib 131, when disassembling the front protective shell 100 and the charging module 200, the deformation required for the first engagement portion 12 and the second engagement portion 13 is reduced, effectively preventing fatigue fracture of the first engagement portion 12 and the second engagement portion 13 due to multiple disassembly operations.

As shown in FIGS. 2-4, the first engagement rib 121 extends at least partially along the first engagement portion 12 and is adjacent to the first main body 11. This reinforces the mechanical strength of the first engagement portion 12, preventing fatigue fracture of the first engagement portion 12 due to multiple disassembly operations. The second engagement rib 131 extends at least partially along the second engagement portion 13 and is adjacent to the first main body 11, thereby reinforcing the mechanical strength of the second engagement portion 13 and preventing fatigue fracture of the second engagement portion 13 due to multiple disassembly operations.

As shown in FIGS. 2-4, the direction from the second engagement portion 13 to the first engagement portion 12 is defined as the second direction Y, which is perpendicular to the first direction X.

In this arrangement, an end of the second engagement portion 13 facing away from the first main body 11 is provided with a handle portion 14. The handle portion 14 extends at least partially in the direction opposite to the first direction X and extends in the direction opposite to the second direction Y; and/or, an end of the first engagement portion 12 away from the first main body 11 is provided with a handle portion 14. The handle portion 14 extends at least partially in the direction opposite to the first direction X and extends in the second direction Y.

In a first embodiment, as shown in FIGS. 2-4, the handle portion 14 is arranged at the end of the second engagement portion 13 facing away from the first main body 11. It extends at least partially in the direction opposite to the first direction X and extends in the direction opposite to the second direction Y, facilitating the user in prying the handle portion. The handle portion 14 drives deformation of the second engagement portion 13, thereby enabling disassembly of the front protective shell 100 from the charging module 200.

In a second embodiment, the handle portion 14 is arranged at the end of the first engagement portion 12 facing away from the first main body 11. It extends at least partially in the direction opposite to the first direction X and extends in the second direction Y, facilitating the user in prying the handle portion 14. The handle portion 14 drives deformation of the first engagement portion 12, thereby enabling disassembly of the front protective shell 100 from the charging module 200.

In a third embodiment, there are two handle portions 14. Two handle portions 14 are respectively arranged on the second engagement portion 13 and the first engagement portion 12. Specifically, one of the two handle portions 14 is arranged at the end of the second engagement portion 13 away from the first main body 11, and the other of the two handle portions 14 is arranged at the end of the first engagement portion 12 facing away from the first main body 11. The handle portion 14 arranged on the second engagement portion 13 extends at least partially in the direction opposite to the first direction X and extends in the direction opposite to the second direction Y, facilitating the user in prying the handle portion 14. The handle portion 14 drives deformation of the second engagement portion 13, thereby enabling disassembly of the front protective shell 100 from the charging module 200. The handle portion 14 arranged on the first engagement portion 12 extends at least partially in the direction opposite to the first direction X and extends in the second direction Y, facilitating the user in prying the handle portion 14. The handle portion drives deformation of the first engagement portion 12, thereby enabling disassembly of the front protective shell 100 from the charging module 200.

The handle portion 14 extends at least partially in the direction opposite to the first direction X, and is configured to provide a fulcrum point when the user applies a force from the charging module 200 towards the handle portion 14, thus making it easier for the user to pry the handle portion 14. The handle portion 14 extends at least partially in the second direction Y or the direction opposite to the second direction Y, creating a gap between the handle portion 14 and the charging module 200. The size of this gap gradually increases in the direction away from the charging module 200, facilitating the user in inserting a finger into the gap. This in turn makes it easier for the user to apply a force that deforms the first engagement portion 12 or the second engagement portion 13, thereby facilitating the disassembly of the charging module 200 from the front protective shell 100.

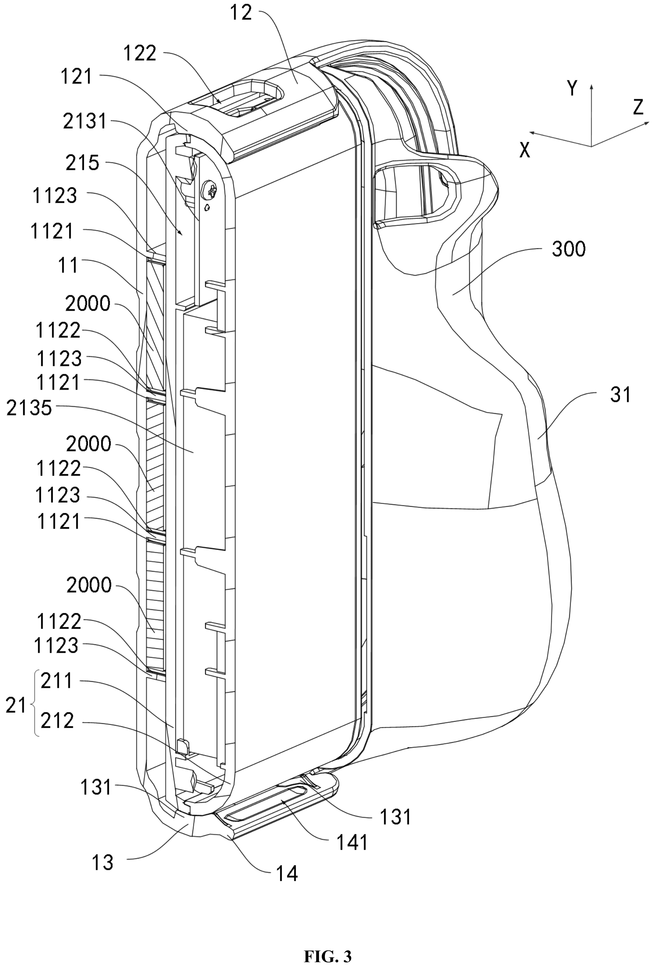

As shown in FIGS. 3-4, a side of the handle portion 14 adjacent to the charging module 200 is provided with a recess 141 configured to allow the user to insert a finger into the recess 141, increasing the contact area between the handle portion 14 and the finger, thereby increasing the friction between the finger and the handle portion 14. This facilitates the user in prying the handle portion 14, and consequently makes it easier to disassemble the front protective shell 100 from the charging module 200.

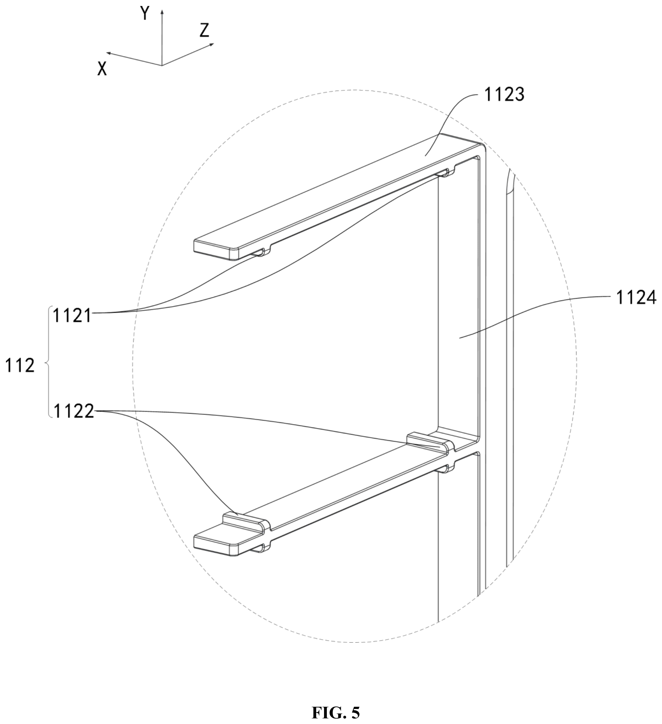

As shown in FIGS. 3-5, a side of the first main body 11 opposite to the first direction X is provided with at least one storage module 112 each configured to store a game cartridge 2000.

Specifically, each storage module 112 includes a first engagement protrusion 1121 and a second engagement protrusion 1122. Both the first engagement protrusion 1121 and the second engagement protrusion 1122 are arranged on the first main body 11. The first engagement protrusion 1121 and the second engagement protrusion 1122 respectively engage with two opposite ends of the game cartridge 2000 in the second direction Y, or respectively engage with opposite ends of the game cartridge 2000 in the third direction Z. The third direction Z is perpendicular to the first direction X, and the third direction Z is perpendicular to the second direction Y. Both the first engagement protrusion 1121 and the second engagement protrusion 1122 form an interference fit with the game cartridge 2000. By engaging the two opposite ends of the game cartridge 2000 with the first engagement protrusion 1121 and the second engagement protrusion 1122, positioning of the game cartridge 2000 is achieved in the direction from the first engagement protrusion 1121 to the second engagement protrusion 1122. Simultaneously, through the interference fit between the first engagement protrusion 1121, the second engagement protrusion 1122, and the game cartridge 2000, shifting of the game cartridge 2000 in the direction perpendicular to the direction from the first engagement protrusion 1121 to the second engagement protrusion 1122 is prevented, thereby securing the game cartridge 2000 in place.

In this embodiment, the direction from the second engagement protrusion 1122 to the first engagement protrusion 1121 is defined as the second direction Y. Each storage module 112 includes two first engagement protrusions 1121 and two second engagement protrusions 1122. The two first engagement protrusions 1121 are arranged and spaced apart along the third direction Z. The two second engagement protrusions 1122 are arranged and spaced apart along the third direction Z. The arrangement of the two second engagement protrusions 1122 and the two first engagement protrusions 1121 prevents a situation where the contact area with the game cartridge 2000 is too small, which may cause the two opposite ends of the game cartridge 2000 in the third direction Z to swing easily, affecting stability of storing the game cartridge 2000.

In this embodiment, there are three storage modules 112 arranged uniformly along the second direction Y. A transverse rib 1123 is provided between each two adjacent storage modules 112. A length direction of the transverse rib 1123 is along the third direction Z. For the storage modules 112 located at opposite ends in the second direction Y, a transverse rib 1123 is provided at an end of the storage module 112 facing away from the adjacent storage module 112, and the length direction of each transverse rib 1123 is along the third direction Z. The arrangement of the transverse ribs 1123 visually separates each two adjacent storage modules 112.

The three storage modules 112 share a common longitudinal rib 1124. A length direction of the longitudinal rib 1124 is along the second direction Y. The longitudinal rib 1124 connects to one end of the transverse rib 1123 in the third direction Z or the direction opposite to the third direction Z. This allows one end of the storage module 112 in the direction opposite to the third direction Z or in the third direction Z to expose the game cartridge 2000, facilitating removal of the game cartridge 2000.

As shown in FIGS. 1-3, the game controller charging device 1000 further includes a controller protective shell 300 detachably connected to the game controller to cover a side of the game controller in the direction opposite to the first direction X.

Specifically, the controller protective shell 300 is provided with a raised grip portion 31 on the side in the direction opposite to the first direction X, configured to allow the user to hold with their hand, thereby improving the user experience. The grip portion 31 is specifically arranged adjacent to an end of the controller protective shell 300 in the direction opposite to the second direction Y. Except for the edge adjacent to the charging module 200, the remaining edges of the controller protective shell 300 extend at least partially toward the front protective shell 100 to wrap around the edges of the game controller on the side in the first direction X. Except for the edge adjacent to the charging module 200, the remaining edges of the first main body 11 extend at least partially in the direction opposite to the first direction X to wrap around the edges of the controller protective shell 300. Through the configuration of the front protective shell 100 and the controller protective shell 300, the game controller is fully protected. Additionally, the controller protective shell 300 can be used in combination with the game controller independently. During gameplay, there is no need to remove the controller protective shell 300, thereby protecting the game controller during use.

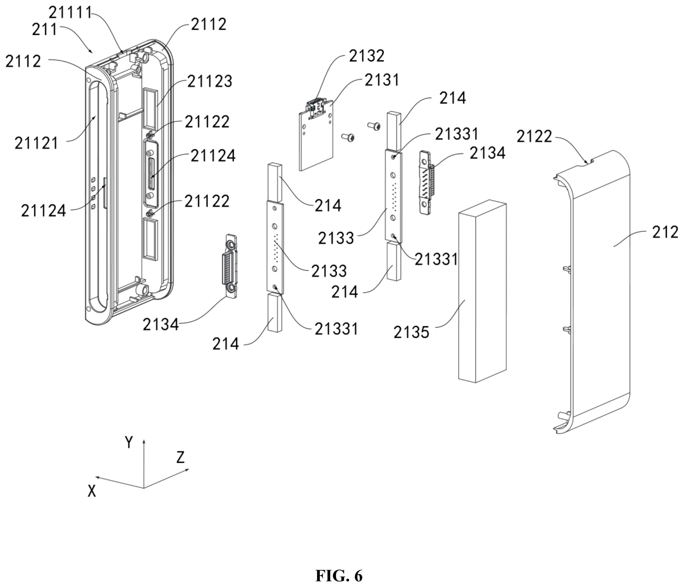

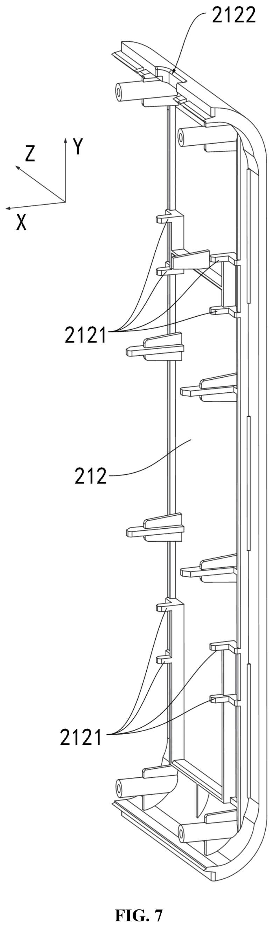

As shown in FIGS. 3, 6, and 7, the charging module 200 includes a housing 21 and a charging assembly. The housing 21 is provided with a mounting groove 21121 configured to accommodate at least a portion of the game controller to enable the housing 21 to be detachably connected to the game controller. The housing 21 defines an accommodation cavity 215, and the charging assembly is at least partially housed within the accommodation cavity 215.

The charging assembly is electrically connected to the game controller and to an external power source to charge the game controller; alternatively, the charging assembly includes a battery cell 2135 electrically connected to the game controller and configured to charge the game controller.

In this embodiment, the charging assembly includes the battery cell 2135. In a first charging scenario, when the charging assembly is not electrically connected to the external power source but is electrically connected to the game controller, power is supplied by the battery cell 2135, meaning the battery cell 2135 is electrically connected to the game controller to charge the game controller.

In a second charging scenario, when the charging assembly is electrically connected to both the external power source and the game controller, power is supplied by the external power source, meaning the charging assembly is electrically connected to the external power source and the game controller, thereby charging the game controller.

In a third charging scenario, when the charging assembly is electrically connected to both the external power source and the game controller, power is supplied by the external power source, meaning the charging assembly is electrically connected to the external power source and the game controller, thereby charging the game controller while simultaneously charging the battery cell 2135.

In a fourth charging scenario, when the charging assembly is electrically connected to the external power source but is not electrically connected to the game controller, power is supplied by the external power source, meaning the charging assembly is electrically connected to the external power source to charge the battery cell 2135.

Specifically, the housing 21 includes a first housing 211 and a second housing 212. The first housing 211 and the second housing 212 together form the accommodation cavity 215. The first housing 211 and the second housing 212 are connected by ultrasonic welding. In other embodiments, the first housing 211 and the second housing 212 may be connected by any one of the following methods: snap-fit connection, heat staking, threaded connection, or slide rail connection.

The first housing 211 includes a second main body 2111 and at least one controller connection portion 2112. In some embodiments, there are two controller connection portions 2112 respectively arranged at two opposite ends of the second main body 2111 in the third direction Z. The controller connection portions 2112 extend at least partially in the direction opposite to the first direction X. A mounting groove 21121 is provided on the side of each controller connection portion 2112 facing away from the other controller connection portion 2112. The mounting groove 21121 is configured to accommodate at least a portion of the game controller, enabling the detachable connection between the game controller and the charging module 200.

In this embodiment, ultrasonic welding grooves are provided at two opposite ends of the second main body 2111 in the second direction Y. Ultrasonic welding grooves are further provided at the ends of the controller connection portions 2112 facing away from the second main body 2111, adjacent to the bottom wall of the mounting groove 21121. The second housing 212 is provided with ultrasonic welding ribs at positions corresponding to these ultrasonic welding grooves. When the first housing 211 and the second housing 212 are assembled into one-unit, ultrasonic welding is performed to join the first housing 211 and the second housing 212 together.

The charging assembly includes a first circuit board 2131, a second circuit board 2133, a charging connector 2132, an electrical connection member 2134, and a battery cell 2135. The charging connector 2132 is mounted on the first circuit board 2131. The first housing 211 is provided with a first charging avoidance groove 21111, and the second housing 212 is provided with a second charging avoidance groove 2122. The first charging avoidance groove 21111 and the second charging avoidance groove 2122 together form a charging avoidance hole. The charging avoidance hole allows at least a portion of the external power source or at least a portion of a charging interface to pass therethrough, thereby enabling the external power source and the charging interface to be electrically connected-that is, enabling the charging assembly to be electrically connected to the external power source.

Specifically, the first engagement portion 12 is provided with a charging avoidance port 122. The charging avoidance port 122 is aligned with the charging avoidance hole, meaning it is aligned with the charging connector 2132. The charging avoidance port 122 is configured to allow the external power source to be electrically connected to the charging connector 2132. This enables charging of the game controller or the battery cell 2135 while the front protective shell 100 and the charging module 200 are assembled together.

The first circuit board 2131 is electrically connected to the second circuit board 2133. The electrical connection member 2134 is mounted on the second circuit board 2133. The bottom wall of the mounting groove 21121 is provided with an electrical connection avoidance hole 21124 configured to allow at least a portion of the electrical connection member 2134 to protrude out and engage the charging port of the game controller, thereby electrically connecting the charging assembly to the game controller. The second circuit board 2133 is thermally fused with the first housing 211.

Specifically, the second circuit board 2133 is provided with heat-melt holes 21331. The bottom wall of the mounting groove 21121, on the side adjacent to the accommodation cavity 215, is provided with heat-melt posts 21122. When the heat-melt posts 21122 pass through the heat-melt holes 21331 and undergo heat-melt treatment, the second circuit board 2133 is heat-melt to the first housing 211. At least a portion of the electrical connection member 2134 is clamped between the second circuit board 2133 and the bottom wall of the mounting groove 21121.

The battery cell 2135 is electrically connected either to the first circuit board 2131 or to the second circuit board 2133, enabling it to charge the game controller or to be charged by the external power source.

A magnetic member 214 is provided in the accommodation cavity 215 and is arranged adjacent to the bottom wall of the mounting groove 21121. The portion of the game controller that engages the mounting groove 21121 is provided with a magnetic mating component. When a part of the game controller is inserted into the mounting groove 21121, the magnetic member 214 and the magnetic mating component magnetically attract each other, establishing a magnetic connection between the game controller and the charging module 200, thereby enhancing the stability of the connection between the game controller and the charging module 200.

The bottom wall of the mounting groove 21121 is provided with a first magnetic positioning portion 21123. The first magnetic positioning portion 21123 extends along the edge of the magnetic member 214 and extends towards the other controller connection portion 2112, thereby restricting movement of the magnetic member 214 in the first direction X and the second direction Y. The second housing 212 is provided with a second magnetic positioning portion 2121 extending at least partially towards the second main body 2111. When the first housing 211 and the second housing 212 are assembled together, the second magnetic positioning portion 2121 abuts against the end of the magnetic member 214 facing away from the mounting groove 21121, while the end of the magnetic member 214 adjacent to the mounting groove 21121 abuts against the bottom wall of the mounting groove 21121, thus restricting movement of the magnetic member 214 in the third direction Z.

## Claims

1. A game controller charging device (1000) for a game controller, wherein the game controller has buttons provided on a first surface in a first direction (X), the game controller charging device (1000) is characterized that, the game controller charging device (1000) comprises a front protective shell (100) and a charging module (200) detachably connected to the game controller, the charging module (200) is configured to charge the game controller, the front protective shell (100) is detachably connected to the charging module (200), and the front protective shell (100) covers a side of the charging module (200) in the first direction (X) and covers a side of the game controller in the first direction (X).

2. The game controller charging device (1000) according to claim 1, wherein the front protective shell (100) comprises a first main body (11), a first engagement portion (12), and a second engagement portion (13), wherein the first main body (11) covers the side of the charging module (200) in the first direction (X) and covers the side of the game controller in the first direction (X); the first engagement portion (12) and the second engagement portion (13) are respectively arranged at two opposite ends of the first main body (11), and the first engagement portion (12) and the second engagement portion (13) engage with the charging module (200) to detachably connect the charging module (200) and the front protective shell (100).

3. The game controller charging device (1000) according to claim 2, wherein the direction from the second engagement portion (13) to the first engagement portion (12) is defined as a second direction (Y), and the second direction (Y) is perpendicular to the first direction (X);
the first engagement portion (12) extends at least partially in a direction opposite to the first direction (X), and an end of the first engagement portion (12) facing away from the first main body (11) extends at least partially in a direction opposite to the second direction (Y), to engage an end of the charging module (200) in the second direction (Y);
the second engagement portion (13) extends at least partially in the direction opposite to the first direction (X), and an end of the second engagement portion (13) facing away from the first main body (11) extends at least partially in the second direction (Y), to engage an opposite end of the charging module (200) in the direction opposite to the second direction (Y).

4. The game controller charging device (1000) according to claim 3, wherein a side of the first engagement portion (12) facing the charging module (200) is provided with a first engagement rib (121), and at least a part of the first engagement rib (121) is arranged adjacent to an end of the first engagement portion (12) facing away from the first main body (11);
a side of the second engagement portion (13) facing the charging module (200) is provided with a second engagement rib (131), and at least a part of the second engagement rib (131) is arranged adjacent to an end of the second engagement portion (13) facing away from the first main body (11).

5. The game controller charging device (1000) according to claim 4, wherein the first engagement rib (121) extends at least partially along the first engagement portion (12) and is adjacent to the first main body (11); and
the second engagement rib (131) extends at least partially along the second engagement portion (13) and is adjacent to the first main body (11).

6. The game controller charging device (1000) according to claim 2, wherein the direction from the second engagement portion (13) to the first engagement portion (12) is defined as a second direction (Y), and the second direction (Y) is perpendicular to the first direction (X);
an end of the second engagement portion (13) facing away from the first main body (11) is provided with a handle portion (14), and the handle portion (14) extends at least partially in a direction opposite to the first direction (X) and extends in a direction opposite to the second direction (Y);
and/or,
an end of the first engagement portion (12) facing away from the first main body (11) is provided with a handle portion (14), and the handle portion (14) extends at least partially in the direction opposite to the first direction (X) and extends in the second direction (Y).

7. The game controller charging device (1000) according to claim 6, wherein a side of the handle portion (14) adjacent to the charging module (200) is provided with a recess (141).

8. The game controller charging device (1000) according to claim 2, wherein a side of the first main body (11) in the direction opposite to the first direction (X) is provided with at least one storage module (112) each configured to store a game cartridge (2000).

9. The game controller charging device (1000) according to claim 1, further comprising a controller protective shell (300), detachably connected to the game controller to cover a side of the game controller in a direction opposite to the first direction (X).

10. The game controller charging device (1000) according to claim 1, wherein the charging module (200) comprises a housing (21) and a charging assembly; the housing (21) is provided with a mounting groove (21121) configured to accommodate at least a portion of the game controller, enabling the housing (21) to be detachably connected to the game controller;
the housing (21) defines an accommodation cavity (215), and the charging assembly is at least partially housed within the accommodation cavity (215);
wherein the charging assembly is electrically connected to the game controller, and the charging assembly is electrically connected to an external power source to charge the game controller;
or, the charging assembly comprises a battery cell (2135) electrically connected to the game controller to charge the game controller.
